# EUROPÄISCHE PATENTSCHRIFT

(11) **EP 1 354 321 B1**
(45) Veröffentlichungstag und Bekanntmachung des Hinweises auf die Patenterteilung: **09.05.2007**
(21) Anmeldenummer: 02704605.1
(22) Anmeldetag: 23.01.2002
(51) Int. Cl.: G11C 11/16

(54) **MRAM-ANORDNUNG**
MRAM ARRANGEMENT
ENSEMBLE MRAM

(30) Priorität: 25.01.2001 DE 10103313
(43) Veröffentlichungstag der Anmeldung: 22.10.2003
(73) Patentinhaber: Infineon Technologies AG, 81669 München (DE)
(72) Erfinder: FREITAG, Martin, 80337 München (DE); ROEHR, Thomas, Yokohama City, 231-0838 (JP)
(74) Vertreter: Kottmann, Heinz Dieter
(86) Internationale Anmeldenummer: PCT/DE2002/000207
(87) Internationale Veröffentlichungsnummer: WO 2002/059898

(56) Entgegenhaltungen:
- EP-A2- 1 316 091
- EP-A2- 1 356 469
- EP-A2- 1 358 679
- US-A- 5 894 447

## Beschreibung

Die vorliegende Erfindung betrifft eine MRAM-Anordnung (MRAM = magnetoresistiver RAM) aus einer Vielzahl von in einer Speichermatrix angeordneten Speicherzellen, deren jede aus wenigstens einer MTJ-Schichtfolge (MTJ = Magnetic Tunnel Junction) und einem Auswahltransistor besteht, von denen die MTJ-Schichtfolgen jeweils zwischen Wortleitungen und Bitleitungen, die im Abstand voneinander verlaufen, gelegen sind, die Auswahltransistoren an ihren Gates zum Auslesen der Speicherzellen mit ersten Selectleitungen (Auswahlleitungen) verbunden sind und die MTJ-Schichtfolgen an zweite Selectleitungen angeschlossen sind.

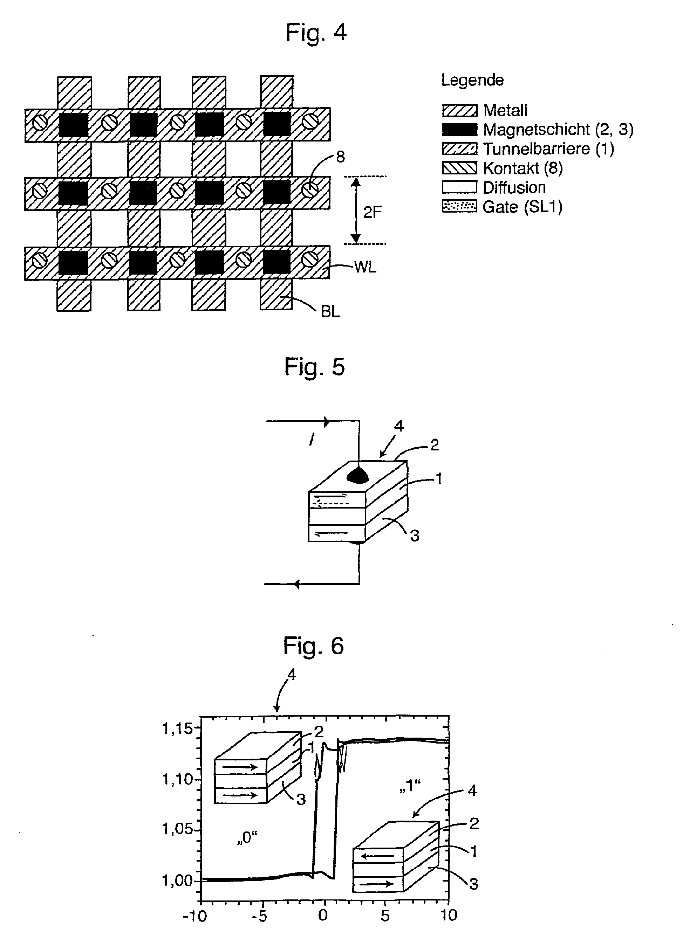

MRAM-Anordnungen - im folgenden auch kurz MRAMs genannt - bestehen in ihrer einfachsten Ausführungsform aus in einer Speichermatrix angeordneten Speicherzellen, deren jede jeweils nur eine MTJ-Schichtfolge aufweist. Eine solche MTJ-Schichtfolge ist in Fig. 5 gezeigt: eine Tunnelbarrierenschicht 1 liegt zwischen einer weichmagnetischen Schicht 2 und einer hartmagnetischen Schicht 3 und besteht aus einer Oxidbarriere. Die Tunnelbarrierenschicht 1, die weichmagnetische Schicht 2 und die hartmagnetische Schicht 3 bilden so eine MTJ-Schichtfolge 4, deren elektrischer Widerstand von der Orientierung der magnetischen Momente in den beiden magnetischen Schichten 2 und 3 abhängt. Sind nämlich die Magnetisierungen in den beiden Schichten 2 und 3 parallel zueinander orientiert, so ist der Widerstand der MTJ-Schichtfolge 4 niedrig, während eine antiparallele Orientierung dieser Magnetisierungen einen höheren Widerstand der MTJ-Schichtfolge ergibt. Die Bestimmung des Zellinhaltes einer aus einer solchen MTJ-Schichtfolge gebildeten Speicherzelle wird dadurch gemessen, dass ein Strom I durch die MTJ-Schichtfolge 4 geschickt wird. Aus der Höhe dieses Stromes I kann dann geschlossen werden, ob die MTJ-Schichtfolge 4 im Zustand eines hohen Widerstandes (antiparallele Orientierung der Magnetisierungen) oder im Zustand eines niedrigen Widerstandes (parallele Orientierung der Magnetisierungen) ist. Jedem dieser Zustände kann dann ein Informationsinhalt "0" bzw. "1" zugeordnet werden.

Dies ist in Fig. 6 schematisch dargestellt, in welcher auf der Abszisse das durch entsprechende Ströme in den Bitleitungen und Wortleitungen erzeugte Magnetfeld und auf der Ordinate der normierte Widerstandswert aufgetragen sind. Deutlich ist zu sehen, dass bei paralleler Orientierung der Magnetisierungen der Widerstand der MTJ-Schichtfolge 4 um etwa 15 % niedriger ist als bei antiparalleler Orientierung. Der parallelen Orientierung der Magnetisierung ist hier der Informationsinhalt "0" zugeordnet, während die antiparallele Orientierung der Magnetisierung den Informationsinhalt "1" hat. Selbstverständlich sind aber auch andere Zuordnungen möglich.

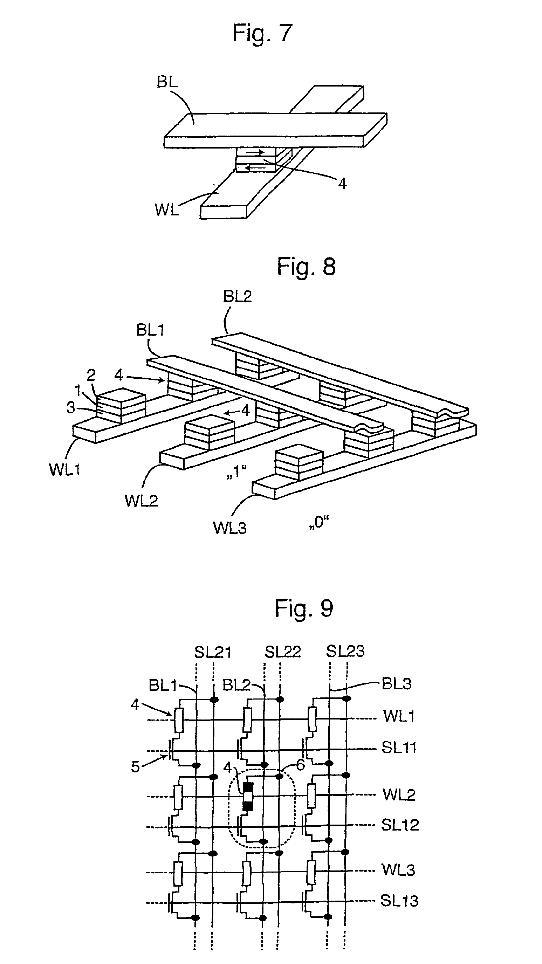

Das Einschreiben in aus MTJ-Schichtfolgen 4 bestehende Speicherzellen erfolgt, indem die Orientierung der magnetischen Momente kontrolliert eingestellt wird. Hierzu wird die Speicherzelle zwischen zwei elektrische Leiter, nämlich eine Bitleitung BL und eine Wortleitung WL plaziert, wie dies in Fig. 7 dargestellt ist. Indem sodann geeignete Ströme durch diese Leitungen BL und WL geschickt werden, kann am Ort der MTJ-Schichtfolge 4, also in der aus dieser bestehenden Speicherzelle, ein Magnetfeld erzeugt werden, durch das die Richtung der magnetischen Momente, also insbesondere die Richtung der magnetischen Momente in der weichmagnetischen Schicht 2, eingestellt werden kann. Um diese Einstellbarkeit der magnetischen Momente in der weichmagnetischen Schicht 2 der MTJ-Schichtfolge 4 zu gewährleisten, ist es in der Regel ausreichend, wenn in einer der Leitungen BL und WL die Richtung des durch diese Leitung fließenden Stromes umgekehrt werden kann. Durch entsprechendes Umschalten der Richtung dieses Stromes ist es also möglich, zwischen paralleler und antiparalleler Orientierung der Magnetisierungen und damit zwischen einem niederohmigen und einem hochohmigen Zustand der Speicherzelle zu schalten.

In Fig. 8 ist der bereits erwähnte einfachste vorstellbare Aufbau einer MRAM-Anordnung dargestellt: MTJ-Schichtfolgen 4, die jeweils Speicherzellen bilden, liegen an den Kreuzungspunkten von jeweils parallel verlaufenden Wortleitungen WL1, WL2, WL3 und Bitleitungen BL1, BL2. Eine bestimmte Speicherzelle wird beschrieben, indem beispielsweise durch die Bitleitung BL2 und die Wortleitung WL3 entsprechende Ströme geschickt werden. An der Kreuzungsstelle der Bitleitung BL2 mit der Wortleitung WL3 (also in Fig. 8 ganz rechts) herrscht dann infolge dieser Ströme ein entsprechendes Magnetfeld, so dass die dort liegende MTJ-Schichtfolge bzw. die durch diese gebildete Speicherzelle entsprechend beschrieben wird.

Vorteilhaft an der in Fig. 8 gezeigten Anordnung ist deren hochdichte Gestaltung: pro Informationsinhalt bzw. Bit wird in vollkommen idealer Weise lediglich eine Fläche von 4 F² benötigt, wobei F die "minimum feature size", also die kleinstmögliche Merkmalsgröße, der verwendeten Technologie bedeutet. Als großer Nachteil einer solchen Gestaltung einer MRAM-Anordnung ist aber anzusehen, dass beim Auslesen infolge der nur geringfügigen Unterschiede im Widerstandswert (etwa 15 %; vgl. oben) erhebliche parasitäre Ströme durch Nachbarzellen fließen, so dass eine solche MRAM-Anordnung insgesamt nur sehr langsam ausgelesen werden kann.

Um diesen Nachteil des langsamen und infolge der parasitären Ströme letztlich auch unsicheren Auslesens der MRAM-Anordnung von Fig. 8 zu vermeiden, wurde bereits ein in Fig. 9 skizzierter MRAM vorgeschlagen, bei dem jede einzelne Speicherzelle aus einer MTJ-Schichtfolge 4 und einem Auswahltransistor 5 besteht. Ein Einschreiben in eine durch eine Strichlinie 6 umgebene Speicherzelle erfolgt, indem durch die Wortleitung WL2 und die Bitleitung BL2 entsprechende Ströme geschickt werden. Dadurch wird die MTJ-Schichtfolge 4 dieser Speicherzelle in entsprechender Weise programmiert. Zum Auslesen werden Selectleitungen SL11 und SL13 so angesteuert, dass die mit diesen verbundenen Auswahltransistoren 5 alle gesperrt sind. Dagegen wird an eine Selectleitung SL12 eine solche Spannung angelegt, dass die mit dieser Leitung verbundenen Auswahltransistoren 5 leiten. Sodann wird an eine Selectleitung SL22 der Selectleitungen SL21 bis SL23 ein Lesesignal angelegt. Dieses fließt über die MTJ-Schichtfolge der durch die Strichlinie 6 umgebenen Speicherzelle, da nur der Auswahltransistor dieser Speicherzelle leitet, während alle anderen Auswahltransistoren der übrigen Speicherzellen gesperrt sind. Am Ausgang der Selectleitung SL22 kann somit ein den Zustand der MTJ-Schichtfolge 4 anzeigendes Signal, also ein Informationsinhalt "0" oder "1" erhalten werden.

Mit der MRAM-Anordnung der Fig. 9 können parasitäre Effekte benachbarter Speicherzellen praktisch ausgeschaltet werden. Somit ist die Zeit für einen Lesezugriff sehr klein. Nachteilhaft an dem MRAM von Fig. 9 ist jedoch, dass der Vorteil einer hochdichten Gestaltung verloren ist, da nur noch eine effektive Zellfläche von 8 F² erreicht werden kann.

Um den obigen Konflikt zwischen Flächenbedarf ("F²") einerseits und schnellem Lesezugriff ohne parasitäre Effekte andererseits zu lösen, wurde bei vollkommen anderen Speicher-Anordnungen, nämlich DRAM-Anordnungen (DRAM = dynamischer RAM) bereits daran gedacht, sogenannte geteilte bzw. "shared contacts" einzusetzen, bei denen ein Kontakt eines Auswahltransistors von mehreren, bevorzugt von zwei Speicherzellen benutzt und damit Fläche ("F²") eingespart wird. Für MRAMs ist diese Lösung aber nicht anwendbar, so dass auch die obige Problematik bisher nicht gelöst wurde.

Es ist somit Aufgabe der vorliegenden Erfindung, eine MRAM-Anordnung zu schaffen, die bei minimalem Flächenbedarf einen raschen Lesezugriff erlaubt.

Diese Aufgabe wird bei einer MRAM-Anordnung der eingangs genannten Art erfindungsgemäß dadurch gelöst, dass in den Speicherzellen jeweils eine MTJ-Schichtfolge und die Drain-Source-Strecke eines Auswahltransistors parallel zueinander liegen, so dass die zweiten Selectleitungen durch die in Reihe zueinander liegenden Source-Drain-Strecken der Auswahltransistoren gebildet sind.

Bei der erfindungsgemäßen MRAM-Anordnung liegen also die Auswahltransistoren und die MTJ-Schichtfolgen der einzelnen Speicherzellen parallel zueinander. Diese Speicherzellen oder "Grundelemente" sind sodann zu Ketten zusammengefügt, wobei parallel zueinander verlaufende Ketten eine Speichermatrix bilden. Die Auswahl einer Kette in einer solchen Speichermatrix kann durch einen gesonderten Auswahltransistor erfolgen. Das heißt, jeder einzelnen Kette wird ein gesonderter Auswahltransistor an einem Ende von der Kette zugeordnet.

Das Einschreiben in die erfindungsgemäße MRAM-Anordnung erfolgt in üblicher Weise, indem an die gewünschten Wort- und Bitleitungen jeweils ein entsprechendes Signal angelegt wird. Beim Auslesen wird über die gesonderten Auswahltransistoren zunächst eine Kette der Speichermatrix festgelegt. Sodann werden alle Transistoren dieser Kette bis auf den Transistor der Speicherzelle, deren Zellinhalt gelesen werden soll, durchgeschaltet. Der Transistor der zu lesenden Speicherzelle bleibt also gesperrt. Wird sodann durch die Kette dieses zu lesenden Transistors ein Strom geschickt, so fließt der Strom allein durch die MTJ-Schichtfolge der zu lesenden Speicherzelle und durch alle Auswahltransistoren der übrigen Speicherzellen der Kette. Damit kann der Zellinhalt der zu lesenden Speicherzelle bestimmt werden.

Die erfindungsgemäße MRAM-Anordnung zeichnet sich durch einen geringen Flächenbedarf aus: in der Kette hat bei entsprechender Gestaltung eine Speicherzelle aus einer MTJ-Schichtfolge und einem parallel zu dieser liegenden Auswahltransistor eine effektive Zellfläche von 4 F². Hierzu muss der gesonderte Auswahltransistor einer Kette gezählt werden, der wiederum eine Fläche von 4 F² benötigt. Damit ergibt sich für eine Kette mit N Speicherzellen eine effektive Zellfläche für jede Speicherzelle von 4 F² (N + 1)/N.

Es sei angemerkt, dass im Falle von N = 1, also einer aus nur einer Speicherzelle bestehenden Kette, eine effektive Zellfläche von 8 F² vorliegt, was genau der bisher bekannten Lösung aus einer Serienschaltung von einem Auswahltransistor mit einer MTJ-Schichtfolge entspricht. Dies bedeutet, dass die Erfindung dann besonders vorteilhaft einsetzbar ist, wenn bei einer MRAM-Anordnung die Bedingung N > 1 vorliegt, was selbstverständlich für sämtliche in Speichermatrizen angeordnete Speicherzellen gilt.

Bei der vorliegenden Erfindung wird in vollkommen neuartiger Weise von dem bisher üblichen Prinzip einer Serienschaltung einer MTJ-Schichtanordnung und eines Auswahltransistors abgegangen und ein neuartiges Konzept vorgeschlagen, bei dem die MTJ-Schichtfolge und der Auswahltransistor in jeder Speicherzelle parallel zueinander liegen und zu Ketten zusammengefügt sind.

Nachfolgend wird die Erfindung anhand der Zeichnungen näher erläutert. Es zeigen:
- Fig. 1: ein schematisches Schaltbild einer Kette einer MRAM-Anordnung gemäß der vorliegenden Erfindung,
- Fig. 2: eine Speichermatrix einer MRAM-Anordnung gemäß der vorliegenden Erfindung,
- Fig. 3: einen Schnitt eines Ausführungsbeispiels der erfindungsgemäßen MRAM-Anordnung,
- Fig. 4: eine Aufsicht auf die MRAM-Anordnung des Ausführungsbeispiels von Fig. 3,
- Fig. 5: eine MTJ-Schichtfolge in Perspektive,
- Fig. 6: eine Darstellung zur Erläuterung des Speicherzustandes in einer MTJ-Schichtfolge gemäß Fig. 5,
- Fig. 7: eine Darstellung einer MTJ-Schichtfolge mit einer Wortleitung und einer Bitleitung,
- Fig. 8: eine Speichermatrix mit MTJ-Schichtfolgen gemäß den Fig. 5 bis 7 und
- Fig. 9: eine Speichermatrix einer herkömmlichen MRAM-Anordnung.

Die Fig. 5 bis 9 sind bereits eingangs erläutert worden.

In den Figuren werden für einander entsprechende Bauteile jeweils die gleichen Bezugszeichen verwendet.

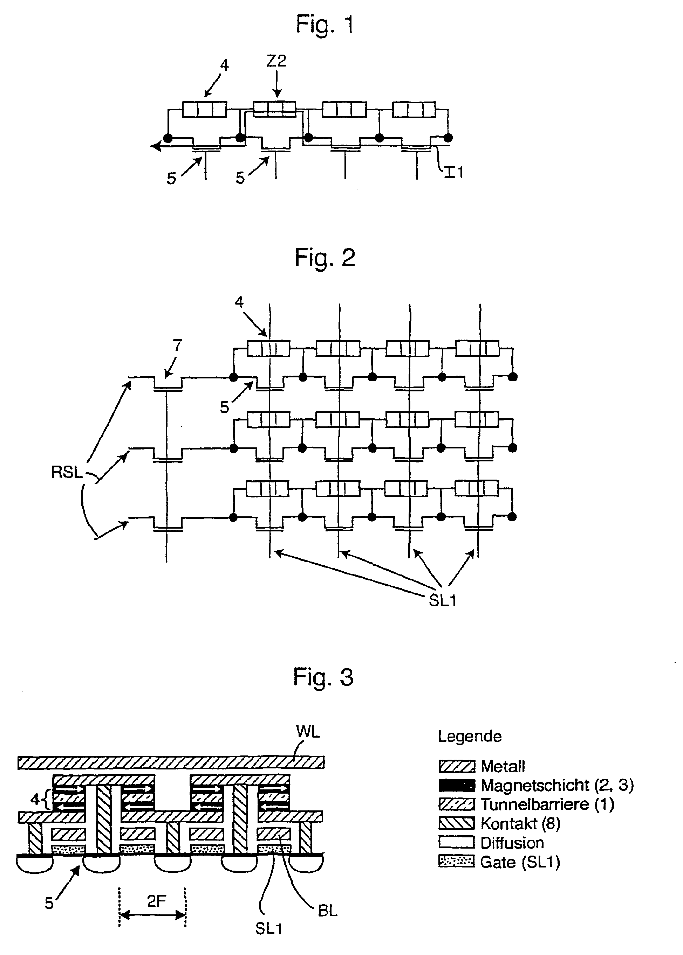

Fig. 1 zeigt eine Kette einer MRAM-Anordnung nach einem Ausführungsbeispiel der vorliegenden Erfindung mit Auswahltransistoren 5 und MTJ-Schichtfolgen 4, die jeweils parallel zueinander liegen. Das heißt, über den Drain-Source-Strecken der Auswahltransistoren 5 liegt jeweils eine MTJ-Schichtfolge 4, welche ihrerseits in der Kette in Reihe zueinander geschaltet sind, wie dies auch für die Drain-Source-Strecken der Auswahltransistoren 5 gilt.

Fig. 2 zeigt ein Ausführungsbeispiel der erfindungsgemäßen MRAM-Anordnung. Hier liegen mehrere der in Fig. 1 gezeigten Ketten mit MTJ-Schichtfolgen 4 und Auswahltransistoren 5 parallel zueinander, wobei zusätzlich mit jeder Kette noch ein gesonderter Auswahltransistor 7 verbunden ist. Zusätzlich sind in Fig. 2 noch erste Selectleitungen SL1 sowie Zeilen- bzw. Row-Selectleitungen RSL gezeigt, die jeweils durch die gesonderten Auswahltransistoren 7 und die Drain-Source-Strecken der Auswahltransistoren 5 gebildet sind.

Soll eine bestimmte Speicherzelle, beispielsweise eine Speicherzelle Z2 der in Fig. 1 gezeigten Kette ausgelesen werden, so wird zunächst der gesonderte Auswahltransistor 7 dieser Kette leitend geschaltet, während alle übrigen gesonderten Auswahltransistoren der Speichermatrix abgeschaltet bzw. nichtleitend verbleiben. Sodann wird in dieser Kette durch Anlegen eines entsprechenden Signales an die der Speicherzelle Z2 zugeordnete Selectleitung SL1 der Auswahltransistor 5 der Speicherzelle Z2 nichtleitend geschaltet, während alle übrigen Auswahltransistoren 5 der Kette in den leitenden Zustand überführt werden. Damit liegt in der Kette ein Strompfad I1 vor, wie dieser in einer Volllinie mit Pfeil schematisch in Fig. 1 angedeutet ist. Dies bedeutet, der Widerstandszustand der MTJ-Schichtfolge der Speicherzelle Z2 kann ohne weiteres ausgelesen werden.

Das Einlesen erfolgt in die in den Fig. 1 und 2 gezeigte MRAM-Anordnung in üblicher Weise. Das heißt, die MTJ-Schichtfolgen 4 liegen jeweils zwischen Bitleitungen BL und Wortleitungen WL, wie dies in einem konkreten Ausführungsbeispiel in den Fig. 3 und 4 dargestellt ist, von denen die Fig. 3 eine Schnittdarstellung und die Fig. 4 eine Aufsicht darstellen. Die neben diesen Figuren gezeigte Legende gilt dabei für beide Figuren.

Wie aus den Fig. 3 und 4 zu ersehen ist, liegen die MTJ-Schichtfolgen 4 zwischen Wortleitungen WL und diese senkrecht kreuzenden Bitleitungen BL. Indem entsprechende Ströme durch die Wortleitungen WL bzw. Bitleitungen BL geschickt werden, können an den Kreuzungsstellen von solchen Wortleitungen und Bitleitungen gelegene MTJ-Schichtfolgen 4 programmiert werden, wie dies oben erläutert wurde.

Das Auslesen erfolgt so, wie dies oben anhand der Fig. 1 und 2 beschrieben wurde: der gesonderte Auswahltransistor 7 der Kette mit der auszulesenden Speicherzelle wird leitend geschalten, während alle anderen gesonderten Auswahltransistoren 7 gesperrt verbleiben. Sodann wird der Auswahltransistor 5 der auszulesenden Speicherzelle in dieser Kette durch entsprechende Ansteuerung der Selectleitung SL1 gesperrt bzw. nichtleitend geschaltet, während alle übrigen Auswahltransistoren dieser Kette durch entsprechende Ansteuerung ihrer Gates über die Selectleitungen SL1 in den leitenden Zustand überführt werden. In der Speicherzelle mit dem gesperrten Transistor, also in der auszulesenden Speicherzelle, fließt dann der Lesestrom über die Row-Selectleitung RSL, das heißt über die Drain-Source-Strecken der Auswahltransistoren der nicht ausgewählten Speicherzellen der Kette und über die MTJ-Schichtfolge 4 der ausgewählten Speicherzelle mit dem gesperrten Auswahltransistor 5. Auf diese Weise kann rasch und ohne parasitäre Ströme der Zellinhalt der ausgewählten Speicherzelle ausgelesen werden.

In den Fig. 3 und 4 sind auch die "minimum feature sizes" F der einzelnen Speicherzellen mit jeweils 2 F veranschaulicht.

Die Erfindung ermöglicht so eine einfach aufgebaute MRAM-Anordnung, die vollkommen von dem bisherigen Konzept einer Reihenschaltung von Auswahltransistor und Speicherzelle abgeht und statt dessen eine Parallelschaltung von Auswahltransistor und MTJ-Schichtfolge vorsieht. Durch diesen anderen Aufbau kann eine hohe Packungsdichte gewährleistet werden, so dass die oben angegebene Aufgabe der Erfindung in hervorragender Weise gelöst wird.

Wie aus Fig. 3 zu ersehen ist, verlaufen bei der erfindungsgemäßen MRAM-Anordnung die Bitleitungen BL oberhalb der Auswahltransistoren 5 und speziell oberhalb von deren Gate-Elektroden im Abstand von diesen.

### Bezugszeichenliste

- 1: Tunnelbarrierenschicht
- 2: weichmagnetische Schicht
- 3: hartmagnetische Schicht
- 4: MTJ-Schichtfolge
- BL, BL1, BL2: Bitleitungen
- WL, WL1, WL2, WL3: Wortleitungen
- 5: Auswahltransistor
- 6: Strichlinie
- 7: gesonderter Auswahltransistor
- Z2: Speicherzelle

## Patentansprüche

1. MRAM-Anordnung aus einer Vielzahl von in einer Speichermatrix angeordneten Speicherzellen (Z2), deren jede aus wenigstens einer MTJ-Schichtfolge (4) und einem Auswahltransistor (5) besteht, wobei die MTJ-Schichtfolgen (4) jeweils bei Wortleitungen (WL) und Bitleitungen (BL), die im Abstand voneinander verlaufen, gelegen sind, die Auswahltransistoren (5) an ihren Gates zum Auslesen der Speicherzellen mit Selectleitungen (SL1) verbunden sind, in den Speicherzellen (Z2) jeweils eine MTJ-Schichtfolge (4) und die Drain-Source-Strecke eines Auswahltransistors (5) parallel zueinander liegen und die Selectleitungen (SL1) über die Gates der Auswahltransistoren (5) geführt sind und parallel zu den Bitleitungen verlaufen,
wobei:
- die MTJ-Schichtfolgen (4) jeweils zwischen den Wortleitungen (WL) und den Bitleitungen (BL) an Kreuzungsstellen von diesen liegen, wobei in Bezug auf die Auswahltransistoren die Wortleitungen (WL) oberhalb und die Bitleitungen (BL) unterhalb von den MTJ-Schichtfolgen (4) verlaufen,
- die Bitleitungen (BL) oberhalb von den Gates der Auswahltransistoren (5) und im Abstand von diesen Gates verlaufen, und
- die Source-Drain-Strecken der Auswahltransistoren (5) einer Kette von Speicherzellen in der Speichermatrix in Reihe zu gesonderten Auswahltransistoren (7) liegen.

2. MRAM-Anordnung nach Anspruch 1,
**dadurch gekennzeichnet,**
**dass** die Auswahltransistoren (5) an ihren Gates mit den Selectleitungen (SL1) verbunden sind.

3. MRAM-Anordnung nach Anspruch 1 oder 2,
**dadurch gekennzeichnet,**
**dass** die Mindestabmessung einer Speicherzelle durch 4 F² gegeben ist, wobei F die "minimum feature size" der verwendeten Technologie bedeutet.

## Claims

1. MRAM arrangement comprising a multiplicity of memory cells (Z2) which are arranged in a memory matrix and each of which comprises at least one MTJ layer sequence (4) and a selection transistor (5), wherein the MTJ layer sequences (4) are in each case located at word lines (WL) and bit lines (BL), which run at a distance from one another, the selection transistors (5) are connected to select lines (SL1) at their gates for reading from the memory cells, in the memory cells (Z2) an MTJ layer sequence (4) and the drain-source path of a selection transistor (5) in each case lie parallel to one another and the select lines (SL1) are routed via the gates of the selection transistors (5) that run parallel to the bit lines,
wherein:
- the MTJ layer sequences (4) in each case lie between the word lines (WL) and the bit lines (BL) at crossover locations thereof, wherein, with regard to the selection transistors, the word lines (WL) run above and the bit lines (BL) run below the MTJ layer sequences (4),
- the bit lines (BL) run above the gates of the selection transistors (5) and at a distance from said gates,
- the source-drain paths of the selection transistors (5) of a chain of memory cells in the memory matrix lie in series with separate selection transistors (7).

2. MRAM arrangement according to Claim 1,
**characterized**
**in that** the selection transistors (5) are connected to the select lines (SL1) at their gates.

3. MRAM arrangement according to Claim 1 or 2,
**characterized**
**in that** the minimum dimension of a memory cell is given by 4 F² where F denotes the minimum feature size of the technology used.

## Revendications

1. Ensemble MRAM constitué d'une pluralité de cellules (Z2) de mémoire disposées suivant une matrice de mémoire, dont chacune est constituée une succession (4) de couches MTJ et d'un transistor (5) de sélection, les successions (4) de couches MTJ étant mises respectivement pour des lignes (WL) de mots et des lignes (BL) de bits, qui s'étendent à distance les unes des autres, les transistors (5) de sélection étant reliés sur leurs grilles, pour lire les cellules de mémoire, à des lignes (SL1) de sélection, dans les cellules (Z2) de mémoire sont disposées parallèlement entre elles, respectivement une succession (4) de couches MTJ et la section de drain-source d'un transistor (5) de sélection et les lignes (SL1) de sélection passant par les grilles des transistors (5) de sélection et s'étendant parallèlement aux lignes de bits.
dans lequel,
- les successions (4) de couches MTJ se trouvent respectivement entre les lignes (WL) de mots et les lignes (BL) de bits en leurs points d'intersection et, par rapport aux transistors de sélection, les lignes (WL) de mots s'étendent au-dessus et les lignes (BL) de bits en dessous des successions (4) de couches MTJ,
- les lignes (BL) de bits s'étendent au- dessus des grilles des transistors (5) de sélection et à distance de ces grilles, et
- les zones de source-drain des transistors (5) de sélection d'une chaîne de cellules de mémoire se trouvent dans la matrice de mémoire en série avec des transistors (7) de sélection séparés.

2. Ensemble MRAM suivant la revendication 1,
**caractérisé en ce que**
les transistors (5) de sélection sont reliés par leurs grilles aux lignes (SL1) de sélection.

3. Ensemble MRAM suivant la revendication 1 ou 2,
**caractérisé en ce que**
la dimension minimum d'une cellule de mémoire est donnée par 4 F², F étant la " minimum feature size" de la technologie utilisée.
